## Europäisches Patentamt
## European Patent Office
## Office européen des brevets

(19)

(11) Veröffentlichungsnummer: **0 260 748 B1**

# EUROPÄISCHE PATENTSCHRIFT

(45) Veröffentlichungstag der Patentschrift: **13.07.94**

(51) Int. Cl.5: **H03M 7/42**, H04N 7/133

(21) Anmeldenummer: **87201717.3**

(22) Anmeldetag: **10.09.87**

(54) **Verfahren und Schaltungsanordung zur Bitratenreduktion.**

(30) Priorität: **13.09.86 DE 3631252**
**08.11.86 DE 3638127**
**23.05.87 DE 3717399**

(43) Veröffentlichungstag der Anmeldung:
**23.03.88 Patentblatt 88/12**

(45) Bekanntmachung des Hinweises auf die
Patenterteilung:
**13.07.94 Patentblatt 94/28**

(84) Benannte Vertragsstaaten:
**AT DE FR GB IT NL SE**

(56) Entgegenhaltungen:
**EP-A- 0 266 049**
**US-A- 4 316 222**
**US-A- 4 698 672**

**IEEE TRANSACTIONS ON COMMUNICA-
TIONS, Band COM-32, Nr. 3, März 1984, Seiten 225-232, IEEE, New York, US; W.-H. CHEN
et al.: "Scene adaptive coder"**

(73) Patentinhaber: **Philips Patentverwaltung
GmbH
Wendenstrasse 35c
D-20097 Hamburg(DE)**

(84) Benannte Vertragsstaaten:
**DE**

(73) Patentinhaber: **N.V. Philips' Gloeilampenfabrieken
Groenewoudseweg 1
NL-5621 BA Eindhoven(NL)**

(84) Benannte Vertragsstaaten:
**FR GB IT NL SE AT**

(72) Erfinder: **Vogel, Peter, Dipl.Ing.
Wöhrletstrasse 7a
D-8566 Diepersdorf(DE)**

(74) Vertreter: **Peuckert, Hermann, Dipl.-Ing. et al
Philips Patentverwaltung GmbH,
Wendenstrasse 35c
D-20097 Hamburg (DE)**

## Beschreibung

Die Erfindung bezieht sich auf ein Verfahren und eine Schaltungsanordnung zur Bitratenreduktion bei der Codierung eines Signals mit einer Folge von Signalwerten, das einen am häufigsten, in ununterbrochenen Teilfolgen vorkommenden, bestimmten Signalwert (A) enthält und aus denen eine Folge von Huffman-Codeworten gebildet wird.

In einem Artikel von Wen-Hsiung Chen und William K. Pratt (Chen, Wen-Hsiung und Pratt, William K.: Scene Adaptive Coder. IEEE Transactions on Communications, Vol. Com-32, No. 3, March 1984, S. 225-232) ist eine Codierung von Videosignalen beschrieben, die das Ziel hat, mit möglichst geringer Bitrate Videobilder ausreichender Qualität zu übertragen. Die Codierung erfolgt in mehreren Schritten. Zunächst werden gleichgroße Ausschnitte eines Videobildes, repräsentiert durch Blöcke von Abtastwerten der Bildpunkte, einer diskreten Cosinus-Transformation unterworfen. Bei dieser Transformation handelt es sich um eine spezielle flächenhafte Fourier-Transformation. Aus dem ursprünglichen Block entsteht nach der Transformation ein neuer Block von Zahlenwerten (Koeffizienten). Dieser Koeffizientenblock hat die Eigenschaft, daß ein großer Teil seiner Elemente - also ein großer Teil der Koeffizienten - nahezu 0 oder exakt 0 ist. Eine anschließende Quantisierung der Koeffizienten macht dann in aller Regel den überwiegenden Teil der Elemente zu 0, so daß eine darauf folgende Huffman-Codierung schon deswegen eine erhebliche Bitratenreduktion bedeuten würde. Zu einer weiteren Bitratenreduktion kommen die Verfasser des oben erwähnten Artikels dadurch, daß sie das häufige Auftreten von ununterbrochenen Teilfolgen von Nullen in dem Zwischensignal, in dem die Koeffizienten seriell angeordnet sind, durch eine Huffman-Codierung ausnutzen.

Bekanntlich werden bei einer Huffman-Codierung, bei der die Codeworte unterschiedliche Länge haben, statistische Eigenschaften des zu codierenden Signales ausgenutzt. Im vorliegenden Falle heißt das insbesondere, daß untersucht wird, mit welcher Häufigkeit in dem oben erwähnten Zwischensignal Teilfolgen von Nullen mit der Länge (runlength) 1, 2, 3 usw. vorkommen. Der Teilfolge mit der größten Häufigkeit wird dann das kürzeste Huffman-Codewort zugeordnet. Der Folge mit der nächst geringeren Häufigkeit wird das nächst größere Codewort zugeordnet und sofort.

Zur Codierung des Zwischensignals werden in dem oben erwähnten Artikel zwei Huffman-Code-Tabellen benötigt. Aus einer ersten Tabelle geht hervor, wie die von 0 verschiedenen (quantisierten) Koeffizienten zu codieren sind. Codiert werden nur die Beträge, weil betragsmäßig gleich große Koeffizienten auch mit der gleichen Häufigkeit vorkommen. Die Vorzeichen werden in einem gesonderten Bit übertragen. Aus einer zweiten Tabelle geht hervor, wie die runlength zu codieren ist. Damit bei der Decodierung die Codeworte der einen Tabelle von denen der anderen zu unterscheiden sind, wird für die Kennzeichnung der codierten runlength ein gesondertes Codewort, das sogenannte runlength prefix verwendet.

Aus der US-A-4 316 222 ist noch ein weiteres Verfahren und eine Vorrichtung zur Kompression und zur Dekompression von digitalen Bilddaten bekannt. Hierbei werden Folgen von Schwarz-Weißbzw. Weiß-Schwarz-Bildpunkten (z.B. für Faksimile) codiert. Die schwarzen Bildpunkte werden durch eine "1" und die weißen Bildpunkte durch eine "0" dargestellt. Eine Schwarz-Weiß-Folge wird zuerst in ein Zahlenpaar umgebildet. Dabei wird die Anzahl der aufeinanderfolgenden "1"-Werte und der direkt anschließende "0"-Wert als erste Zahl des Zahlenpaares angegeben, die gleich der Anzahl der "1"-Werte ist. Die zweite Zahl des Zahlenpaares ist gleich der um eins reduzierten Anzahl der aufeinanderfolgenden "0"-Werte. Bei der Bildung eines Zahlenpaares für Weiß-Schwarz-Folgen wird als erste Zahl die Anzahl der aufeinanderfolgenden "0"-Werte und als zweite Zahl die um eins reduzierte Anzahl der anschließenden, aufeinanderfolgenden "1"-Werte genommen. Aus dem Zahlenpaar wird dann ein Codewort gebildet. Als ein Codewort kann nur eine bestimmte Länge von "1"- oder "0"-Werten codiert werden. Wenn eine solche Folge von "1"- oder "0"-Werten einen bestimmte Länge überschreitet, findet ein Wechsel zwischen der Codierung von Weiß-Schwarz-Folgen zu Schwarz-Weiß-Folgen oder umgekehrt statt. Bei einer zu langen Folge von "1"- oder "0"-Werten, wird beispielsweise zuerst der erste Teil der Weiß-Schwarz-Folge als Zahlenpaar einer Weiß-Schwarz-Folge und der restliche Teil als Schwarz-Weiß-Folge codiert. Bei diesem Verfahren können ausschließlich Schwarz-Weiß-Bilder codiert werden. Außerdem müssen zwei unterschiedliche Teilfogen codiert werden, wodurch das Verfahren aufwendig ist.

Der Erfindung liegt die Aufgabe zugrunde, bei einem Signal mit den eingangs genannten Merkmalen, das als Sonderfall ein bei der Bildcodierung auftretendes Zwischensignal enthält, ein Codierverfahren anzugeben, das zu einer größeren als bisher bekannten Bitratenreduktion führt.

Diese Aufgabe wird bei einem Verfahren der eingangs genannten Art dadurch gelöst,
daß wenigstens ein Huffman-Codewort
- entweder aus einem anderen Signalwert und aus einer nachfolgenden, ununterbrochenen Teilfolge des bestimmten Signalwertes (A), wenn diese vorhanden ist,

- oder aus einem anderen Signalwert und aus einer vorangehenden, ununterbrochenen Teilfolge des bestimmten Signalwertes (A), wenn diese vorhanden ist,

gebildet wird und

daß bei der Bildung der Folge der Codeworte nur die vorangehenden oder nur die nachfolgenden Teilfolgen des bestimmten Signalwertes (A) mit dem anderen Signalwert verwendet werden.

Vorteilhafte Ausgestaltungen der Erfindung - insbesondere für Sonderfälle des eingangs charakterisierten Signals - sowie eine Schaltungsanordnung zur Bitratenreduktion sind weiteren Ansprüchen zu entnehmen.

Anhand eines Beispiels und anhand der Figuren soll die Erfindung näher erläutert werden.

Es zeigen:

Fig. 1 eine Ereignistabelle mit der Häufigkeitsverteilung der Ereignisse,

Fig. 2 eine weitere Ereignistabelle, durch die die Zerlegung von Ereignissen verdeutlicht wird,

Fig. 3 bis Fig. 5 eine Codierungstabelle mit zwei Fortsetzungen und

Fig. 6 das Prinzipschaltbild einer Anordnung zur erfindungsgemäßen Codierung von Videosignalen.

In dem nun folgenden Beispiel zur Erläuterung der Erfindung handelt es sich bei dem zu codierenden Signal um das in der Einleitung erwähnte Zwischensignal, das bei der blockweisen Codierung von Videobildern auftritt. Die eingangs erwähnten Signalwerte sind also die Koeffizienten bzw. die Elemente des Koeffizientenblockes, der Signalwert A ist der Wert 0, denn dieser kommt in dem Zwischensignal am häufigsten in ununterbrochenen Teilfolgen vor.

Wie der erfindungsgemäßen Lehre zu entnehmen ist, wird das Auftreten einer ununterbrochenen Teilfolge von Nullen und des sich dieser Teilfolge anschließenden Koeffizienten als ein zu codierendes Ereignis angesehen. Wichtig ist, daß auch das Auftreten keiner Null vor einem von 0 verschiedenen Koeffizienten - also das Auftreten einer Teilfolge der Länge 0 - als zu codierendes Ereignis behandelt wird.

Jedes dieser Ereignisse tritt im Videosignal mit einer charakteristischen Häufigkeit auf. Wie z.B. Messungen er geben haben, treten Koeffizienten mit kleinem Betrag zunehmend häufiger als solche mit großem Betrag auf, je länger die vorangegangene Teilfolge von Koeffizienten mit dem Betrage 0 wird.

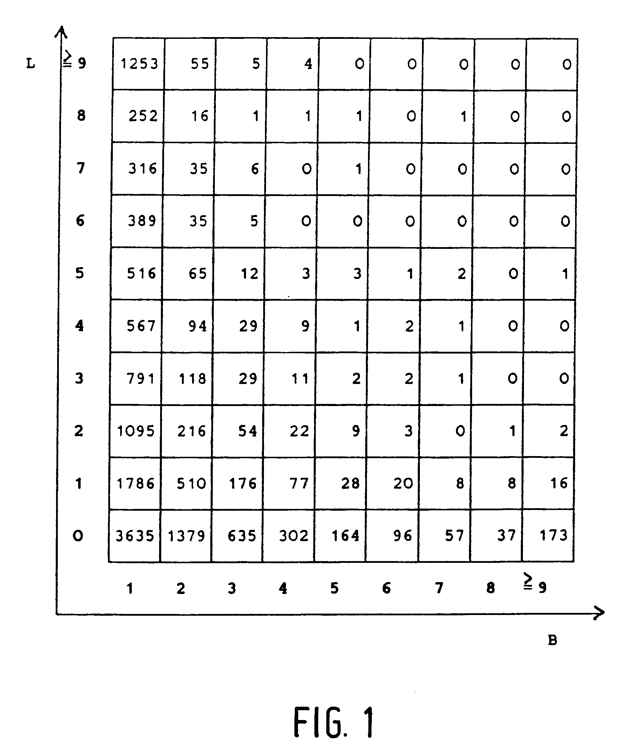

Figur 1 (Tabelle I) zeigt die Häufigkeitsverteilung der oben angesprochenen Ereignisse bei einem cosinus-transformierten und anschließend quantisierten Videosignal. Jedes Feld der Tabelle stellt ein Ereignis dar, das durch die Länge L der ununterbrochenen Teilfolgen von Nullen und durch den Betrag B des sich anschließenden (quantisierten) Koeffizienten charakterisiert ist. Die Beträge B durchlaufen die natürlichen Zahlen ohne die Null und die Länge L durchläuft die natürlichen Zahlen mit der Null. Damit die Tabelle nicht beliebig groß wird, sind alle Ereignisse mit B größer oder gleich 9 zu einem Gesamtereignis zusammengefaßt. Entsprechendes gilt für L größer oder gleich 9.

Die Zahlen in den Feldern geben an, wie oft das zugehörige Ereignis in einem quantisierten Videosignal mit etwa 15 000 Signalwerten auftritt. Die Zuordnung von Huffman-Codeworten macht die Tabelle offensichtlich:

das Ereignis L = 0, B = 1 bekommt das kürzeste Codewort; es folgt das Ereignis L = 1, B = 1 mit dem nächstlängeren Codewort und so fort.

Trägt man in die Ereignisfelder der Tabelle statt der Häufigkeiten die zugeordneten Codeworte ein, so ergibt sich eine zweidimensionale Codierungstabelle. Sie ist für die Ereignisse nach Tabelle I nicht angegeben, weil das Aufstellen solcher Codierungstabellen in aller Regel zum handwerklichen Können des Fachmannes gehört. Ergänzend sei angemerkt, daß bei den Ereignissen mit L größer oder gleich 9 oder mit B größer oder gleich 9 nach dem zugeordneten Huffman-Codewort noch maximal 11 Bits folgen, durch die der Empfänger eine genaue nformation über die Größe L bzw. über die Größe B erhält.

Eine Codierung von Videosignalen nach der oben angedeuteten zweidimensionalen Codierungstabelle ergibt gegenüber der eingangs beschriebenen Codierung eine zusätzliche Bitratenreduktion von 12%.

Diese zusätzliche Bitratenreduktion ist deshalb möglich, weil z.B. die Wahrscheinlichkeit des Ereignisses, bei dem drei aufeinanderfolgende Nullen mit anschließendem Koeffizienten vom Betrage 2 auftreten, verschieden ist vom Produkt der Wahrscheinlichkeit, mit der drei aufeinanderfolgende Nullen auftreten, und der Wahrscheinlichkeit, mit der ein Koeffizient vom Betrage 2 überhaupt auftritt.

Genauer betrachtet werden soll nun die Begrenzung der Tabelle I (Fig. 1). Wie den obenstehenden Ausführungen zu entnehmen ist, wird die Zahl der zu codierenden Ereignisse nach Tabelle I dadurch in zweckmäßigen Grenzen gehalten, daß alle Teilfolgen von Nullen mit gleichgroßem sich anschließendem Betrag eines Koeffizienten dann als ein Ereigniss angesehen werden, wenn die Länge L der Teilfolgen größer als acht ist.

Ebenso werden alle Nullfolgen gleicher Länge dann als ein Ereignis angesehen, wenn der sich anschließende Betrag B eines Koeffizienten größer als acht ist.

Bei den eben aufgezählten Ereignissen handelt es sich -wie die Tabelle I zeigt - um relativ seltene Ereignisse; sie werden daher mit relativ langen Huffman-Codeworten codiert. Da der Empfänger zur Decodierung ohne Informationsverlust die genaue Länge einer Nullfolge oder den genauen Betrag eines Koeffizienten wissen muß, wird - wie oben schon angedeutet - an das Huffman-Codewort ein Zusatzcodewort gehängt, dem die genaue Länge oder der genaue Betrag oder beides zu entnehmen ist.

Durch das Huffman-Codewort und die Zusatzinformation wird ein scharf umrissener Sachverhalt codiert. Da die Anzahl der Bits derartiger Kombinationen ebenfalls von den statistischen Eigenschaften des Signals abhängig ist, sollen hier solche Kombinationen ebenfalls als Huffman-Codeworte bezeichnet werden, die als ganzes dem Empfänger bzw Decodierer vorliegen müssen, damit der Sachverhalt, der ihnen zugrundeliegt, eindeutig auf der Empfängerseite erkannt werden kann.

Die in diesem Sinne definierten Huffman-Codeworte können bis zu 30 Bit lang werden. Da die Verarbeitung von maximal 16 Bit langen Codeworten keine besonderen Einrichtungen erforderlich macht, sondern z.B. mit einem 16-Bit-Mikroprozessor möglich ist, werden - zur Verbesserung des bisher geschilderten Verfahrens - bestimmte Ereignisse derart in Teilereignisse zerlegt, daß zur Codierung aller Ereignisse und Teilereignisse Codeworte ausreichen, deren Länge maximal 16 Bit beträgt. Diese Zerlegung soll nun verdeutlicht werden.

Zunächst wird ein zu codierendes Ereignis, das aus einer ununterbrochenen Teilfolge von L = Lm Nullen mit anschließendem Koeffizienten vom Betrage B = Bm besteht, durch (Lm, Bm) symbolisiert. Im Gegensatz zu dem bisher gesagten wird nun ausdrücklich auch Bm = 0 zugelassen. Die in der Praxis auftretende zweidimensionale Mannigfaltigkeit von Ereignissen (Lm, Bm) ist zwar endlich, da nicht beliebig große Beträge von Koeffizienten vorkommen, jedoch sehr groß. Folglich sind auch die zu verwendenden Huffman-Codeworte nach Anzahl und Länge entsprechend groß. Zur Reduzierung der Gesamtzahl der zu codierenden Ereignisse wird nun davon ausgegangen, daß z.B. eine Teilfolge von 19 Nullen mit anschließenden Koeffizienten vom Betrage 7 sich in Abschnitte zerlegen läßt, von denen der erste eine ununterbrochene Teilfolge von 16 Nullen, der zweite eine ununterbrochene Teilfolge von 3 Nullen ist und der dritte eine Teilfolge mit keiner Null und anschließendem Koeffizienten vom Betrage 7 darstellt. Jeder dieser Abschnitte wird nun als Teilereignis angesehen, das durch ein Huffman-Codewort codiert wird. Die Länge eines jeden dieser Abschnitte liegt unter einem vorgebbaren Wert, auf den weiter unten eingegangen wird.

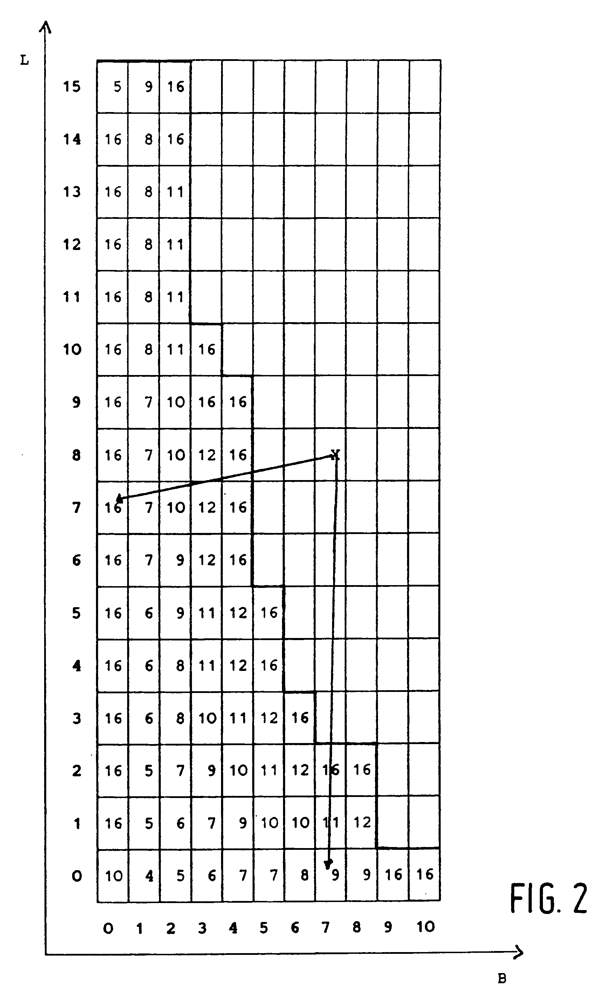

Der Versinnbildlichung dieser Zerlegung dient die Fig. 2 (Tabelle II). In waagerechter Richtung sind alle vorkommenden Beträge B - einschließlich der Betrag 0 - von Koeffizienten aufgetragen. In senkrechter Richtung ist die Länge - ebenfalls angefangen bei 0 - von ununterbrochenen Teilfolgen von Koeffizienten mit dem Betrage 0 aufgetragen.

Die eingetragenen "Ereignisfelder" symbolisieren die Ereignisse (Lm, Bm), d.h., Lm Nullen gefolgt von einem Koeffizienten vom Betrage Bm. Das Ereignis (0, 3) z.B. bedeutet, daß einem Koeffizienten vom Betrage 3 eine Teilfolge der Länge 0 vorangegangen ist, was gleichbedeutend damit ist, daß vor ihm kein Koeffizient vom Betrage 0 steht. Isoliert stehende Nullen im Signal werden durch das Ereignis (0, 0) symbolisiert. Die Angabe (3, Bm) u.a. bedeutet das Ereignis, daß auf drei aufeinanderfolgende Nullen ein Koeffizient vom Betrage Bm folgt. Da für Bm auch der Wert Null zugelassen ist, bedeutet das Ereignis (3, 0) vier aufeinanderfolgenden Nullen.

Die Tabelle II enthält einen fettgedruckten Polygonzug, der die Ereignisfelder in zwei Bereiche teilt. Der linke Bereich enthält die hier codierbar genannten Ereignisse, der rechte Bereich die hier nichtcodierbar genannten Ereignisse. Die maximale Länge, die ein Abschnitt von Signalwerten haben darf - er entspricht einem codierbaren Ereignis - ist 16; es handelt sich um die Ereignisse (15, 0), (15, 1) und (15, 2). Alle anderen codierbaren Ereignisse entsprechen Signalabschnitten, die kürzer sind. Die Einteilung in codierbare und nichtcodierbare Ereignisse ist nicht völlig willkürlich; die am häufigsten auftretenden Ereignisse müssen zu den codierbaren gehören. Die nichtcodierbaren Ereignisse werden dann in codierbare zerlegt. Das angekreuzte nichtcodierbare Ereignis (8, 7) in Tabelle II wird z.B. in die Ereignisse (0, 7) und (7, 0) zerlegt. Für die Zerlegung gibt es mehrere Möglichkeiten; die einfachste ist die hier angegebene "Projektion auf die Ereignisachsen".

Die Zahlen in den Ereignisfeldern, die zu den codierbaren Ereignissen gehören, bedeuten die Länge - also die Anzahl der Bits - der Huffman-Codeworte, mit denen die Ereignisse codiert werden. Die Codeworte enthalten auch das Vorzeichen der Koeffizienten und gegebenenfalls Angaben über die Größe des Betrages B; keines von ihnen ist länger als 16 Bit. Bei der Aufstellung der Huffman-Codeworte wurde unterstellt, daß Koeffizienten mit Beträgen größer als 136 nicht vorkommen.

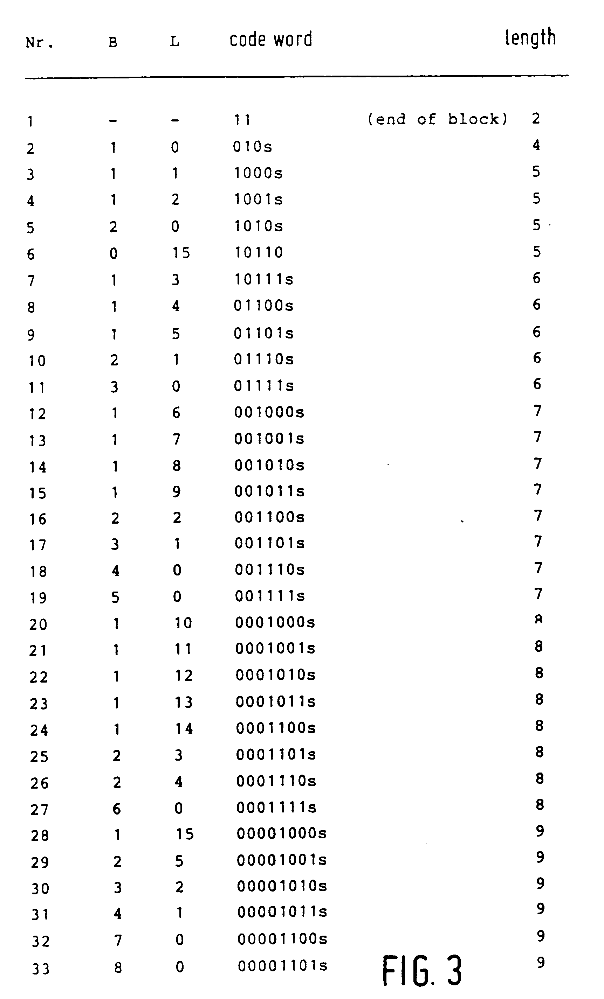

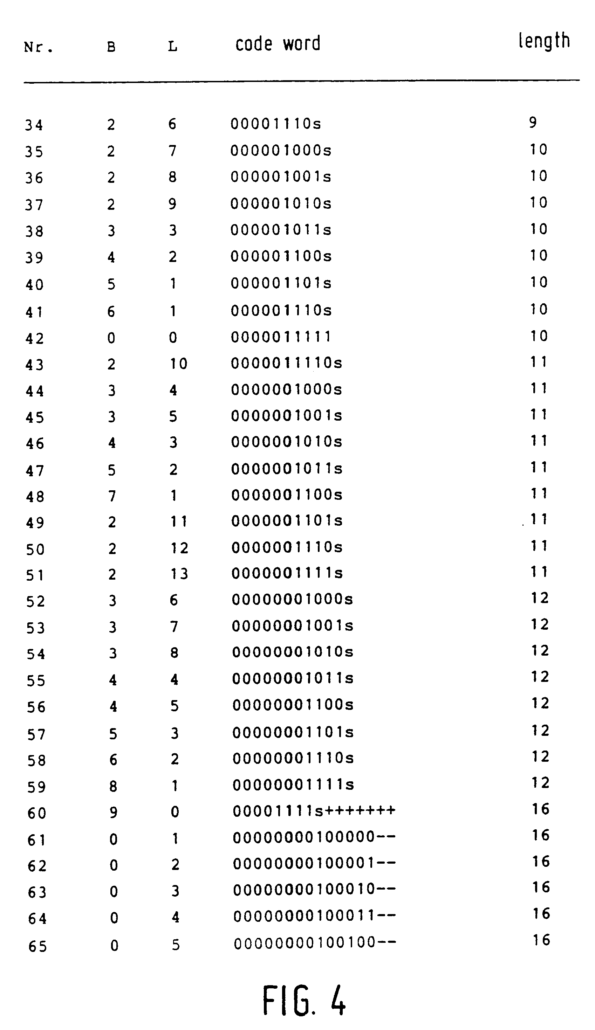

Die Figuren 3 bis 5 (Tabelle III) zeigen die genaue Struktur der verwendeten Huffman-Codeworte. Das erste Codewort stellt den codierten Signalwert zur Kennzeich nung eines Blockendes dar; es folgt bei der übertragung auf das letzte Codewort, das zu einem Koeffizientenblock gehört. Die erste Spalte der Tabelle III enthält eine laufende Nummer, die zweite Spalte den Betrag B der Koeffizienten und die dritte die Länge L der Nullfolgen. Die beiden letzten Angaben zusammen ergeben die "Koordinaten" eines codierbaren Ereignisses nach Tabelle II. In der vierten Spalte der Tabelle III sind die Codeworte bitweise angegeben. Das Bit s bedeutet das Vorzeichenbit, die mit "-" versehenen Stellen sind bedeutungslos und in die mit "+" versehenen Stellen werden die codierten Beträge der Koeffizienten eingetragen, sofern sie größer als acht sind. Die letzte Spalte gibt noch einmal die Länge der Huffman-Codeworte wieder.

Eine Möglichkeit zur weiteren Reduktion der Bitrate ergibt sich aus der Tatsache, daß - wie im vorliegenden Beispiel - das zu codierende Signal nach Blöcken strukturiert ist. Wie schon angedeutet, sind die Koeffizienten eines Koeffizientenblokkes von denen des nächstfolgenden Blockes durch ein "end-of-block"-Signal voneinander getrennt. Auch dieses "end-of-block"-Signal wird in ein Codewort umgesetzt (vergleiche Fig. 3), während die Folge der Koeffizienten eines Blocks in eine Folge von m (codierbaren) Ereignissen der Art

(L1, B1)
(L2, B2)
...
(Lm, Bm)      (1)

bzw. in eine Folge von zugeordneten Codeworten aufgelöst wird. Wie groß die Anzahl m der Ereignisse ist, hängt von den speziellen Werten der Koeffizienten ab. Besteht der gesamte Koeffizientenblock z.B. aus 63 Nullen mit an schließendem Koeffizienten vom Betrag 1, so zerfällt er nur in ein Ereignis, nämlich (63,1), bzw. in mehrere codierbare Ereignisse nach Tabelle II. Da also von vornherein nicht feststeht, in wieviele codierbare Ereignisse ein Koeffizientenblock zerlegt wird, müssen schon aus diesem Grunde die einzelnen Blöcke durch ein "end-ofblock"-Signal voneinander getrennt werden. Auf der Empfangsseite werden die übertragenen Huffman-Codeworte wieder in Ereignisse zurücktransformiert und diese Ereignisse wiederum in eine Folge von Koeffizienten. Dem Empfänger ist bekannt, daß zu einem Koeffizientenblock z.B. 64 Koeffizienten gehören

Zur weiteren Erläuterung wird der Einfachheit halber angenommen, daß es sich um 4 x 4-Blöcke handelt, ein Block also insgesamt 16 Elemente enthält. Alle Daten, die zu einem Block gehören, sind von den Daten des nächstfolgen den Blocks durch ein "end-of-block"-Zeichen getrennt. Dieses Zeichen bzw. das entsprechende Codewort wird von der Zerlegung des zu codierenden Signals nach Ereignissen ausgenommen.

Hat z.B. die Folge von Koeffizienten eines Blocks in dezimaler Darstellung die Gestalt

XX      4005000050000001      XX ,      (2)

so zerfällt nach dem Schema (1) der Block in folgende Ereignisse:

(0,4)
(2,5)
(4,5)
(6,1).      (3)

Damit die Koeffizientenfolge eines Blocks überhaupt in Ereignisse nach dem Schema (1) oder (3) zerlegt werden kann, werden die Koeffizienten vor ihrer weiteren Verarbeitung zwischengespeichert. Die zeitliche Reihenfolge der Koeffizienten im Schema (2) und die der Ereignisse in den Schemata (1) und (3) entsPricht der Reihenfolge ihrer schriftlichen Aufzeichnung (europäische Schreibrichtung vorausgesetzt). Die Zeichen XX im Beispiel nach dem Schema (2) symbolisieren die "end-of-block"-Zeichen des vorangegangenen Blockes und des dargestellten Blocks.

Die von 0 verschiedenen Koeffizienten im Schema (2) sind alle positiv und als ganze Vielfache der kleinsten Einheit, nämlich 1, dargestellt. Wie aus dem Schema (3) ersichtlich, ist das letzte Ereignis das Ereignis (6, 1). Die den Ereignissen zugeordnete Huffman-Codeworte sind nicht eingetragen.

Nun wird zunächst geprüft, welches Gewicht für den Empfänger der Empfang des letzten Ereignisses, nämlich (6, 1) des Blocks nach (2) hat. Als allgemeine Erfahrungsregel hat sich bei der Bildcodierung herausgestellt, daß die Übertragung von Ereignissen mit einer Folge von mehr als fünf Nullen immer weniger lohnend wird, je kleiner der Betrag des sich anschließenden Koeffizienten ist. Stellt man die durch die Erfahrung gestützte Regel auf, geprüfte Ereignisse, für die $L \geq 5$ und $B = 1$ ist, nicht zu übertragen, so unterbleibt die Übertragung des letzten Ereignisses. Sodann wird das vorangegangene Ereignis (4, 5) nach dem gleichen Kriterium überprüft. Im Beispiel nach (2) ist dann für diesen Block die Prüfung beendet, da das Ereignis (4, 5) bzw. das zugeordnete Huffman-Codewort übertragen werden muß.

Nach der Decodierung der Huffman-Codeworte auf der Empfängerseite lassen sich alle Koeffizienten des Blocks nach dem Schema (2) wiedergewinnen, bis auf diejenigen, die zu nicht übertragenen Ereignissen gehören. Da diese jedoch zu den letzten Koeffizienten des Blocks gehören, werden auf der Empfängerseite den decodierten Koeffizienten so viele Koeffizienten vom Betrag 0 angefügt, bis die Gesamtzahl der Koeffizienten 16 beträgt.

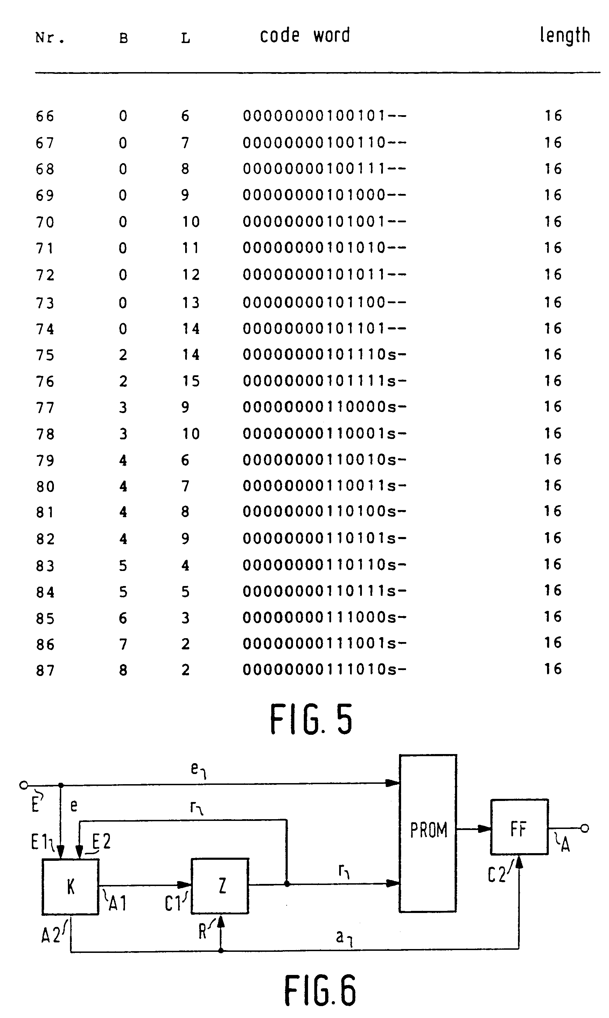

Figur 6 zeigt eine Schaltungsanordnung (Prinzipschaltbild), die eine einfache Zerlegung der Folge von Koeffizienten nach codierbaren Ereignissen vornimmt. Die Taktversorgung und Details der logischen Verknüpfung von binären Größen sind z.B. nicht abgebildet, da derartige Dinge zum handwerklichen Können des Fachmanns gehören. Bei der Schaltung nach Figur 6 werden Ereignisse codiert, die aus einer ununterbrochenen Teilfolge von Koeffizienten mit dem Betrage Null und einem sich anschließenden Koeffizienten bestehen. Überschreitet die Länge L einer ununterbrochenen Teilfolge im zu codierenden Signal eine fest vorgegebene Länge Lmax, so gilt das zugehörige Ereignis als nicht codierbar und wird in codierbare Ereignisse zerlegt. Wegen der fest vorgegebenen, vom Betrag des sich anschließenden Koeffizienten unabhängigen Maximallänge Lmax, sind keine Verzögerungen bzw. Zwischenspeicherungen der Koeffizienten erforderlich.

Die Koeffizienten werden seriell von einem Eingang E über eine Mehrfachleitung e an die Adresseingänge eines adressierbaren Speichers PROM und an einen ersten Eingang E1 einer Komparatorschaltung K gegeben. Die Mehrfachleitung e enthält soviele Adern wie Bits zur binären Darstellung eines Koeffizienten erforderlich sind. Im Speicher PROM ist eine Codiertabelle abgelegt.

Einem zweiten Eingang E2 des Komparators K wird - über eine Mehrfachleitung r - der Stand eines Zählers Z zugeführt. Die Mehrfachleitung r ist gleichzeitig an weitere Adresseingänge des Speichers PROM geführt.

Es sei nun angenommen, daß am Eingang E1 ein von Null verschiedener Koeffizient anliegt. In diesem Fall gibt die Komparatorschaltung K an einem Ausgang A2 einen Impuls ab, der über eine Leitung a an den Rücksetzeingang R des Zählers Z und an den Takteingang C2 einer Flip-Flop-Schaltung FF geführt wird. Mit diesem Impuls wird der Zähler auf den Stand Null zurückgesetzt und das am Ausgang des Speichers PROM anliegende Codewort bitparallel in die Flip-Flop-Schaltung FF übernommen. Das Codewort ist am Ausgang A der Schaltung nach Fig. 6 abnehmbar. Die am Ausgang A anliegenden Codeworte sind nicht die endgültigen Huffman-Codeworte, da sie alle die gleiche Länge haben. Zur Umwandlung von Codeworten gleicher Länge in solche ungleicher Länge und umgekehrt die letzte Umwandlung ist auf der Empfängerseite notwendig - wird auf die Patentanmeldungen DE 35 10 902, DE 35 10 901 und DE 36 32 682 verwiesen.

Liegt am Eingang E1 eine Null an, dann gibt die Komparatorschaltung K an einem weiteren Ausgang A1 einen Zählimpuls an den Takteingang C1 des Zählers Z ab, der den Zählerstand um eine Einheit erhöht. Die Komparatorschaltung K vergleicht laufend den aktuellen Zählerstand mit der Größe Lmax, die in einem ihrer nicht eingezeichneten Speicher abgelegt ist. Erreicht der Zählerstand den Wert Lmax, so unterbleibt die Abgabe eines weiteren Zählimpulses; stattdessen wird am Ausgang A2 der Rücksetzbzw. Übernahmeimpuls abgegeben.

In der Schaltung nach Figur 6 werden die vollständigen Koeffizienten - also auch ihre Vorzeichen - verarbeitet. In einer Variante ist vorgesehen, das Vorzeichen der Koeffizienten über eine gesonderte Ader an den Ausgang A der Schaltungsanordnung zu leiten und es vom Vergleich durch die Komparatorschaltung K und zur Bestimmung des Codewortes durch den Programmierbaren Speicher PROM auszunehmen.

**Patentansprüche**

1. Verfahren zur Bitratenreduktion bei der Codierung eines Signals mit einer Folge von Signalwerten, das einen am häufigsten, in ununterbrochenen Teilfolgen vorkommenden, bestimmten Signalwert (A) enthält und aus denen eine Folge von Huffman-Codeworten gebildet wird,
   dadurch gekennzeichnet,
   daß wenigstens ein Huffman-Codewort
   - entweder aus einem anderen Signalwert und aus einer nachfolgenden, ununterbrochenen Teilfolge des bestimmten Signalwertes (A), wenn diese vorhanden ist,
   - oder aus einem anderen Signalwert und aus einer vorangehenden, ununterbrochenen Teilfolge des bestimmten Signalwertes (A), wenn diese vorhanden ist,
   gebildet wird und
   daß bei der Bildung der Folge der Codeworte nur die vorangehenden oder nur die nachfolgenden Teilfolgen des bestimmten Signalwertes (A) mit dem anderen Signalwert verwendet werden.

2. Verfahren nach Anspruch 1,
   dadurch gekennzeichnet,
   daß an das Huffman-Codewort ein Zusatzcodewort gehängt wird, dem die genaue Länge oder der genaue Betrag oder beides zu entnehmen ist, wenn die Teilfolge des bestimmten Signalwertes (A) eine vorgegebene Länge und/oder der zugeordnete andere Signalwert einen vorgegebenen Betrag überschreitet.

3. Verfahren nach Anspruch 1,
   dadurch gekennzeichnet,
   daß dann, wenn eine Teilfolge des bestimmten Signalwertes (A) zusammen mit dem zugeordneten anderen Signalwert eine vorgegebene Länge überschreitet, diese gesamte Wertefolge so in Abschnitte zerlegt wird, daß die Länge eines jeden Abschnittes unter einem vorgegebenen Wert liegt, und daß jedem Abschnitt ein Huffman-Codewort zugeordnet wird.

4. Verfahren nach Anspruch 1, 2 oder 3,
dadurch gekennzeichnet,
daß es sich bei dem Signal um eine Folge von Koeffizienten handelt, die sich nach der blockweisen Cosinus-Transformation von Bildpunkten eines Videosignales mit anschließender Quantisierung ergibt und daß der bestimmte Signalwert (A) der Wert Null ist.

5. Verfahren nach Anspruch 1, 2 oder 3,
dadurch gekennzeichnet,
daß bei einem in gleichlange Blöcke strukturierten Signal geprüft wird, welche Vorteile und Nachteile die Nichtübertragung des letzten Huffman-Codewortes eines Blockes hat und daß dann, wenn die Vorteile überwiegen, das Huffman-Codewort nicht übertragen wird.

6. Verfahren nach Anspruch 5,
dadurch gekennzeichnet,
daß bei Nichtübertragung des letzten Huffman-Codewortes die gleiche Prüfung mit dem vorangegangenen Huffman-Codewort als letztem Huffman-Codewort wiederholt wird.

7. Verfahren nach Anspruch 5 oder 6,
dadurch gekennzeichnet,
daß ein überprüftes Huffman-Codewort nicht übertragen wird, wenn die Länge der zugehörigen Teilfolge des bestimmten Signalwertes (A) eine vom Betrag des sich anschließenden Signalwertes abhängige Schranke übertrifft.

8. Verfahren nach Anspruch 7,
dadurch gekennzeichnet,
daß es sich bei dem Signal um eine Folge von Koeffizienten handelt, die sich nach der blockweisen Cosinus-Transformation von Bildpunkten eines Videosignales mit anschließender Quantisierung ergibt, und daß der bestimmte Signalwert (A) der Wert Null ist und daß ein überprüftes Huffman-Codewort nicht übertragen wird, wenn die Länge der zugehörigen Teilfolge von Nullen größer als Fünf ist und der Betrag des sich anschließenden Signalwertes der kleinstmögliche Wert verschieden von Null ist.

9. Verfahren nach Anspruch 4 oder 8,
dadurch gekennzeichnet,
daß das Huffman-Codewort unabhängig von dem Vorzeichen desjenigen Koeffizienten ist, der sich auf die Folge von Nullen anschließt oder ihr vorangeht, und daß das Vorzeichen durch ein gesondertes Bit codiert wird.

10. Schaltungsanordnung zur Bitratenreduktion bei der Codierung eines Signals mit einer Folge von Signalwerten, das einen am häufigst in ununterbrochenen Teilfolgen vorkommenden, bestimmten Signalwert enthält und aus denen eine Folge von Huffman-Codeworten gebildet wird,
dadurch gekennzeichnet,
daß Mittel (K, Z, PROM, FF) vorgesehen sind, die wenigstens ein Huffman-Codewort,
- entweder aus einem anderen Signalwert und aus einer nachfolgenden, ununterbrochenen Teilfolge des bestimmten Signalwertes, wenn diese vorhanden ist,
- oder aus einem anderen Signalwert und aus einer vorangehenden, ununterbrochenen Teilfolge des bestimmten Signalwertes, wenn diese vorhanden ist,
bilden und
daß bei der Bildung der Folge der Codeworte nur die vorangehenden oder nur die nachfolgenden Teilfolgen des bestimmten Signalwertes mit dem anderen Signalwert verwendet werden.

11. Schaltungsanordnung nach Anspruch 10,
dadurch gekennzeichnet,
daß die Mittel ein Speichermittel (PROM) enthalten, das zur Bildung eines an das Huffman-Codewort anzuhängenden Zusatzcodewortes vorgesehen sind, dem die genaue Länge oder der genaue Betrag oder beides zu entnehmen ist, wenn die Teilfolge des bestimmten Signalwertes (A) eine vorgegebene Länge und/oder der zugeordnete andere Signalwert einen vorgegebenen Betrag überschreitet.

12. Schaltungsanordnung nach Anspruch 10 oder 11,
dadurch gekennzeichnet,
daß das Mittel (K, Z, PROM, FF) zum Empfang des Signals vorgesehen ist,
daß das Signal eine Folge von Koeffizienten enthält, die sich nach der blockweisen Cosinus-Transformation von Bildpunkten eines Videosignales mit anschließender Quantisierung ergibt, und
daß der bestimmte Signalwert (A) der Wert Null ist.

13. Schaltungsanordnung nach Anspruch 10,
dadurch gekennzeichnet,
daß die Mittel ein Vergleichsmittel (K,FF) enthalten, das bei einem in gleichlange Blöcke strukturierten Signal zur Prüfung vorgesehen ist, welche Vorteile und Nachteile die Nichtübertragung des letzten Huffman-Codewortes eines Blockes hat, und

daß dann, wenn die Vorteile überwiegen, das Vergleichsmittel (K, FF) zur Verhinderung einer Übertragung des Huffman-Codewortes vorgesehen ist.

14. Schaltungsanordnung nach Anspruch 13, dadurch gekennzeichnet, daß das Vergleichsmittel (K,FF) zur Übertragung eines überprüften Huffman-Codewortes vorgesehen ist, wenn die Länge der zugehörigen Teilfolge von Signalwerten A eine vom Betrag des sich anschließenden Signalwertes abhängige Schranke übertrifft.

15. Schaltungsanordnung nach Anspruch 12, dadurch gekennzeichnet, daß das Speichermittel (PROM) vorgesehen ist, das Huffman-Codewort unabhängig von dem Vorzeichen desjenigen Koeffizienten zu wählen, der sich auf die Folge von Nullen anschließt oder ihr vorangeht, und das Vorzeichen durch ein gesondertes Bit zu codieren.

16. Schaltungsanordnung nach Anspruch 12, dadurch gekennzeichnet, daß die binär codierten Koeffizienten mit vorgebbaren Verzögerungen den Adresseingängen eines Speichers (PROM) und einem ersten Eingang (E1) einer Komparatorschaltung (K) zugeführt werden, daß ein Zähler (Z) vorgesehen ist, dessen binär codierter Zählerstand weiteren Adresseingängen des Speichers (PROM) sowie einem zweiten Eingang (E2) der Komparatorschaltung (K) zugeführt wird, daß die Komparatorschaltung (K) an einem ersten Ausgang (A1) einen Zählimpuls an den Zähler (Z) abgibt, wenn am ersten Eingang (E1) ein Koeffizient mit dem Wert Null anliegt und der Zählerstand einen in einem Speicher der Komparatorschaltung (K) gespeicherten Wert nicht überschritten hat, und daß die Komparatorschaltung (K) an einem zweiten Ausgang (A2) einen Impuls abgibt, wenn die Bedingungen für die Abgabe eines Zählimpulses nicht erfüllt sind, und daß mit dem Impuls am zweiten Ausgang (A2) der Komparatorschaltung (K) der Zähler (Z) zurückgesetzt und das an den Ausgängen des Speichers (PROM) anliegende Codewort in einen Zwischenspeicher (FF) übernommen wird.

17. Schaltungsanordnung nach Anspruch 16, dadurch gekennzeichnet, daß nur die Beträge der Koeffizienten den Adresseingängen des Speichers (PROM) und der Komparatorschaltung (K) zugeführt werden und daß das Vorzeichenbit der Koeffizienten über eine gesonderte Ader an den Ausgang (A) der Schaltungsanordnung geleitet wird.

**Claims**

1. A method of bitrate reduction when coding a signal which comprises a sequence of signal values and has a signal value (A) occurring most frequently in runs and from which a series of Huffman codewords is formed characterized in that at least a Huffman codeword is formed
   - either from a different signal value and from a subsequent run of the given signal value (A), when available,
   - or from a different signal value and from a preceding run of the given signal value (A), when available,
   and in that in the formation of the series of codewords only the preceding or only the subsequent runs of the given signal value (A) are used with the different signal value.

2. A method as claimed in Claim 1, characterized in that the Huffman codeword has an additional codeword associated with it, from which the exact length or the exact value or both can be derived, if the run of the given signal value (A) exceeds a predetermined length and/or if the assigned other signal value exceeds a predetermined value.

3. A method as claimed in Claim 1, characterized in that if a run of the given signal value A together with the assigned other signal value exceeds a predetermined length, said overall run is split up into sections in such a manner that the length of each section is below a predetermined value, and in that a Huffman codeword is assigned to each section.

4. A method as claimed in Claim 1, 2 or 3, characterized in that the signal comprises a sequence of coefficients which results after blockwise cosine transform of pixels of a video signal with subsequent quantisation, and in that the given signal value (A) is the zero value.

5. A method as claimed in Claim 1, 2 or 3, characterized in that the advantages and drawbacks of non-transmission of the last Huffman codeword of a block are checked in a signal having the structure of equally long blocks, and in that in the case of the advantages prevailing the Huffman codeword is not transmitted.

6. A method as claimed in Claim 5, characterized in that in the case of non-transmission of the last Huffman codeword the same check with the preceding Huffman codeword as last Huffman codeword is repeated.

7. A method as claimed in Claim 5 or 6, characterized in that a checked Huffman codeword is not transmitted if the length of the associated run of the given signal value (A) exceeds a barrier which is dependent on the magnitude of the subsequent signal value.

8. A method as claimed in Claim 7, characterized in that the signal comprises a sequence of coefficients which results after a blockwise cosine transform of pixels of a video signal with subsequent quantisation and in that the given signal value (A) is the zero value, and in that a checked Huffman codeword is not transmitted if the length of the associated zero run is larger than five and if the magnitude the subsequent signal value has the smallest possible value different from zero.

9. A method as claimed in Claim 4 or 8, characterized in that the Huffman codeword is independent of the sign of that coefficient which succeeds or precedes the zero run and in that the sign is coded by means of a separate bit.

10. A circuit arrangement for bitrate reduction when coding a signal which comprises a sequence of signal values and has a signal value occurring most frequently in runs and from which a series of Huffman codewords is formed, characterized in that means (K, Z, PROM, FF) are provided which form at least a Huffman codeword
   - either from a different signal value and from a subsequent run of the given signal value, when available,
   - or from a different signal value and from a preceding run of the given signal value, when available,
and in that in the formation of the series of codewords only the preceding or only the subsequent runs of the given signal value are used with the different signal value.

11. A circuit arrangement as claimed in Claim 10, characterized in that the means comprise a storage means (PROM) which is provided for forming an additional codeword to be associated with the Huffman codeword, from which additional codeword the exact length or the exact value or both can be derived, if the run of the given signal value (A) exceeds a predetermined length and/or if the assigned other signal value exceeds a predetermined value.

12. A circuit arrangement as claimed in Claim 10 or 11, characterized in that the means (K, Z, PROM, FF) is provided for receiving the signal, in that the signal comprises a sequence of coefficients which results after blockwise cosine transform of pixels of a video signal with subsequent quantisation, and in that the given signal value (A) is the zero value.

13. A circuit arrangement as claimed in Claim 10, characterized in that the means comprise a comparison means (K, FF) which is provided for checking the advantages and drawbacks of non-transmission of the last Huffman codeword of a block in a signal having the structure of equally long blocks, and in that in the case of the advantages prevailing the comparison means (K, FF) is provided for preventing transmission of the Huffman codeword.

14. A circuit arrangement as claimed in Claim 13, characterized in that the comparison means (K, FF) is provided for transmitting a checked Huffman codeword if the length of the associated run of signal values A exceeds a barrier which is dependent on the magnitude of the subsequent signal value.

15. A circuit arrangement as claimed in Claim 12, characterized in that the storage means (PROM) is provided for selecting the Huffman codeword independently of the sign of that coefficient which succeeds or precedes the zero run, and for coding the sign by means of a separate bit.

16. A circuit arrangement as claimed in Claim 12, characterized in that the binary coded coefficients are applied with predeterminable delays to the address inputs of a memory (PROM) and to a first input (E1) of a comparator circuit (K), in that a counter (Z) is provided whose binary coded count is applied to further address inputs of the memory (PROM) and to a second input (E2) of the comparator circuit (K), in that the comparator circuit (K) supplies a counting pulse to the counter (Z) from a first output (A1) if a zero value coefficient is present at the first input (E1) and if the count has not exceeded a value stored in a memory of the comparator circuit (K), and in that the comparator circuit (K) supplies a pulse from a second output (A2) if the conditions for the supply of a counting pulse are not fulfilled, and in that the counter (Z) is reset by means of the pulse at the second output (A2) of the comparator circuit (K) and the codeword present at the outputs of the memory (PROM) is transferred to an intermediate memory (FF).

17. A circuit arrangement as claimed in Claim 16, characterized in that only the values of the coefficients are applied to the address inputs of the memory (PROM) and the comparator circuit (K) and in that the sign bits of the coefficients are supplied through a separate wire to the output (A) of the circuit arrangement.

**Revendications**

1. Procédé de réduction du débit de bits lors du codage d'un signal constitué d'une séquence de valeurs de signal, qui contient une valeur de signal déterminée (A) apparaissant le plus fréquemment dans des séquences partielles ininterrompues et à partir desquelles une séquence de mots de code de Huffman est formée, caractérisé en ce qu'au moins un mot de code de Huffman est formé
   - soit à partir d'une autre valeur de signal et d'une séquence partielle ininterrompue suivante de la valeur de signal déterminée (A) lorsque celle-ci est présente,
   - soit à partir d'une autre valeur de signal et d'une séquence partielle ininterrompue précédente de la valeur de signal déterminée (A), lorsque celle-ci est présente, et

   lors de la formation de la séquence de mots de code, on n'utilise que les séquences partielles précédentes ou suivantes de la valeur de signal déterminée (A) avec l'autre valeur de signal.

2. Procédé selon la revendication 1, caractérisé en ce que l'on rattache au mot de code de Huffman un mot de code supplémentaire d'où l'on tire la longueur exacte ou la valeur exacte ou les deux, lorsque la séquence partielle de la valeur de signal déterminée (A) dépasse une longueur prédéterminée et/ou que l'autre valeur de signal affectée dépasse une valeur prédéterminée.

3. Procédé selon la revendication 1, caractérisé en ce qu'ensuite, lorsqu'une séquence partielle de la valeur de signal déterminée (A), conjointement avec l'autre valeur de signal affectée, dépasse une longueur prédéterminée, cette séquence de valeurs totale est décomposée en sections, de telle sorte que la longueur de chaque section se situe en dessous d'une valeur prédéterminée et qu'à chaque section est affecté un mot de code de Huffman.

4. Procédé selon la revendication 1, 2 ou 3, caractérisé en ce qu'il s'agit, dans le cas du signal, d'une séquence de coefficients qui s'obtient après transformation cosinus par blocs de points d'image d'un signal vidéo avec quantification ultérieure et que la valeur de signal déterminée (A) est la valeur zéro.

5. Procédé selon la revendication 1, 2 ou 3, caractérisé en ce que l'on contrôle, dans la cas d'un signal structuré en blocs de même longueur, les avantages et les inconvénients de la non-transmission du dernier mot de code de Huffman d'un bloc et qu'ensuite, lorsque les avantages l'emportent, on ne transmet pas le mot de code de Huffman.

6. Procédé selon la revendication 5, caractérisé en ce que, dans le cas de non-transmission du dernier mot de code de Huffman, on répète le même contrôle avec le mot de code de Huffman précédent à titre de dernier mot de code de Huffman.

7. Procédé selon la revendication 5 ou 6, caractérisé en ce que l'on ne transmet pas un mot de code de Huffman contrôlé lorsque la longueur de la séquence partielle associée de la valeur de signal déterminée (A) dépasse une limite dépendant de la valeur du signal qui s'y rattache.

8. Procédé selon la revendication 7, caractérisé en ce qu'il s'agit dans la cas du signal d'une séquence de coefficients qui s'obtient après transformation cosinus par blocs de points d'image d'un signal vidéo avec quantification ultérieure et que la valeur de signal déterminée (A) est la valeur zéro et qu'un mot de code de Huffman contrôlé n'est pas transmis lorsque la longueur de la séquence partielle associée de zéros est supérieure à cinq et que le niveau de la valeur de signal qui s'y rattache est la valeur la plus petite possible différente de zéro.

9. Procédé selon la revendication 4 ou 8, caractérisé en ce que le mot de code de Huffman est indépendant du signe du coefficient qui suit ou précède la séquence de zéros et que le signe est codé par un bit séparé.

10. Montage de circuit de réduction du débit de bits lors du codage d'un signal constitué d'une séquence de valeurs de signal, qui contient une valeur de signal déterminée apprarissant

le plus fréquemment dans des séquences partielles ininterrompues et à partir desquelles on forme une séquence de mots de code de Huffman, caractérisé en ce que des moyens (K, Z, PROM, FF) sont prévus qui forment au moins un mot de code de Huffman :

- soit à partir d'une autre valeur de signal et d'une séquence partielle ininterrompue suivante de la valeur de signal déterminée, lorsque celle-ci est présente,
- soit à partir d'une autre valeur de signal et d'une séquence partielle ininterrompue précédente de la valeur de signal déterminée, lorsque celle-ci est présente, et que, lors de la formation de la séquence de mots de code, on n'utilise que les séquences partielles précédentes ou suivantes de la valeur de signal déterminée avec l'autre valeur de signal.

11. Montage de circuit selon la revendication 10, caractérisé en ce que lesdits moyens contiennent des moyens de mémorisation (PROM) qui sont prévus pour former un mot de code complémentaire à rattacher au mot de code de Huffman sur lequel on prélèvera la longueur ou la valeur exacte ou les deux, lorsque la séquence partielle de la valeur de signal déterminée (A) dépasse une longueur prédéterminée et/ou que l'autre valeur de signal affectée dépasse une valeur prédéterminée.

12. Montage de circuit selon la revendication 10 ou 11, caractérisé en ce que les moyens (K, Z, PROM, FF) sont prévus pour recevoir le signal, que le signal contient une séquence de coefficients qui s'obtient après transformation cosinus par blocs de points d'image d'un signal vidéo avec quantification extérieure, et que la valeur de signal déterminée (A) est la valeur zéro.

13. Montage de circuit selon la revendication 10, caractérisé en ce que lesdits moyens contiennent des moyens de comparaison (K, FF) qui sont prévus, dans le cas d'un signal structuré en blocs de longueur égale, pour vérifier les avantages et les inconvénients de la non-transmission du dernier mot de code de Huffman d'un bloc et en ce que, ensuite, lorsque les avantages l'emportent, les moyens de comparaison (K, FF) sont prévus pour empêcher une transmisssion du mot de code de Huffman.

14. Montage de circuit selon la revendication 13, caractérisé en ce que les moyens de comparaison (K, FF) sont prévus pour la transmission d'un mot de code de Huffman contrôlé lorsque la longueur de la séquence partielle associée de valeurs de signal A dépasse une limite dépendant du niveau de la valeur du signal qui s'y rattache.

15. Montage de circuit selon la revendication 12, caractérisé en ce que les moyens de mémorisation (PROM) sont prévus pour choisir le mot de code de Huffman indépendamment du signe du coefficient qui termine ou précède la séquence de zéros et pour coder le signe par un bit séparé.

16. Montage de circuit selon la revendication 12, caractérisé en ce que les coefficients à codage binaire sont acheminés avec des temporisations prédéterminables aux entrées d'adressage d'une mémoire (PROM) et à une première entrée (E1) d'un circuit comparateur (K), qu'un compteur (Z) est prévu dont le comptage à codage binaire est acheminé à d'autres entrées d'adressage de la mémoire (PROM) ainsi qu'à une deuxième entrée (E2) du circuit comparateur (K), que le circuit comparateur (K) délivre à une première sortie (A1) une impulsion de comptage au compteur (Z) lorsque à la première entrée (E1) se trouve un coefficient de valeur zéro et que le comptage n'a pas dépassé une valeur mémorisée dans une mémoire du circuit comparateur (K), que le circuit comparateur (K) délivre, à une deuxième sortie (A2), une impulsion lorsque les conditions de délivrance d'une impulsion de comptage ne sont pas remplies et que, par l'impulsion délivrée à la deuxième sortie (A2) du circuit comparateur (K), le compteur (Z) est remis à zéro et le mot de code appliqué aux sorties de la mémoire (PROM) est pris en charge dans une mémoire tampon (FF).

17. Montage de cicruit selon la revendication 16, caractérisé en ce que seuls les niveaux des coefficients sont acheminés aux entrées d'adressage de la mémoire (PROM) et au circuit de comparaison (K) et que le bit de signe des coefficients est acheminé via un conducteur séparé à la sortie (A) du montage de circuit.

| | 1 | 2 | 3 | 4 | 5 | 6 | 7 | 8 | ≥9 |
|---|---|---|---|---|---|---|---|---|---|
| ≥9 | 1253 | 55 | 5 | 4 | 0 | 0 | 0 | 0 | 0 |
| 8 | 252 | 16 | 1 | 1 | 1 | 0 | 1 | 0 | 0 |
| 7 | 316 | 35 | 6 | 0 | 1 | 0 | 0 | 0 | 0 |
| 6 | 389 | 35 | 5 | 0 | 0 | 0 | 0 | 0 | 0 |
| 5 | 516 | 65 | 12 | 3 | 3 | 1 | 2 | 0 | 1 |
| 4 | 567 | 94 | 29 | 9 | 1 | 2 | 1 | 0 | 0 |
| 3 | 791 | 118 | 29 | 11 | 2 | 2 | 1 | 0 | 0 |
| 2 | 1095 | 216 | 54 | 22 | 9 | 3 | 0 | 1 | 2 |
| 1 | 1786 | 510 | 176 | 77 | 28 | 20 | 8 | 8 | 16 |
| 0 | 3635 | 1379 | 635 | 302 | 164 | 96 | 57 | 37 | 173 |

L ↑     B →

## FIG. 1

| L \ B | 0 | 1 | 2 | 3 | 4 | 5 | 6 | 7 | 8 | 9 | 10 |
|---|---|---|---|---|---|---|---|---|---|---|---|
| 15 | 5 | 9 | 16 | | | | | | | | |
| 14 | 16 | 8 | 16 | | | | | | | | |
| 13 | 16 | 8 | 11 | | | | | | | | |
| 12 | 16 | 8 | 11 | | | | | | | | |
| 11 | 16 | 8 | 11 | | | | | | | | |
| 10 | 16 | 8 | 11 | 16 | | | | | | | |
| 9 | 16 | 7 | 10 | 16 | 16 | | | | | | |
| 8 | 16 | 7 | 10 | 12 | 16 | | | X | | | |
| 7 | 16 | 7 | 10 | 12 | 16 | | | | | | |
| 6 | 16 | 7 | 9 | 12 | 16 | | | | | | |
| 5 | 16 | 6 | 9 | 11 | 12 | 16 | | | | | |
| 4 | 16 | 6 | 8 | 11 | 12 | 16 | | | | | |
| 3 | 16 | 6 | 8 | 10 | 11 | 12 | 16 | | | | |
| 2 | 16 | 5 | 7 | 9 | 10 | 11 | 12 | 16 | 16 | | |
| 1 | 16 | 5 | 6 | 7 | 9 | 10 | 10 | 11 | 12 | | |
| 0 | 10 | 4 | 5 | 6 | 7 | 7 | 8 | 9 | 9 | 16 | 16 |

FIG. 2

| Nr. | B | L | code word | | length |
|---|---|---|---|---|---|
| 1 | - | - | 11 | (end of block) | 2 |
| 2 | 1 | 0 | 010s | | 4 |
| 3 | 1 | 1 | 1000s | | 5 |
| 4 | 1 | 2 | 1001s | | 5 |
| 5 | 2 | 0 | 1010s | | 5 |
| 6 | 0 | 15 | 10110 | | 5 |
| 7 | 1 | 3 | 10111s | | 6 |
| 8 | 1 | 4 | 01100s | | 6 |
| 9 | 1 | 5 | 01101s | | 6 |
| 10 | 2 | 1 | 01110s | | 6 |
| 11 | 3 | 0 | 01111s | | 6 |
| 12 | 1 | 6 | 001000s | | 7 |
| 13 | 1 | 7 | 001001s | | 7 |
| 14 | 1 | 8 | 001010s | | 7 |
| 15 | 1 | 9 | 001011s | | 7 |
| 16 | 2 | 2 | 001100s | | 7 |
| 17 | 3 | 1 | 001101s | | 7 |
| 18 | 4 | 0 | 001110s | | 7 |
| 19 | 5 | 0 | 001111s | | 7 |
| 20 | 1 | 10 | 0001000s | | 8 |
| 21 | 1 | 11 | 0001001s | | 8 |
| 22 | 1 | 12 | 0001010s | | 8 |
| 23 | 1 | 13 | 0001011s | | 8 |
| 24 | 1 | 14 | 0001100s | | 8 |
| 25 | 2 | 3 | 0001101s | | 8 |
| 26 | 2 | 4 | 0001110s | | 8 |
| 27 | 6 | 0 | 0001111s | | 8 |
| 28 | 1 | 15 | 00001000s | | 9 |
| 29 | 2 | 5 | 00001001s | | 9 |
| 30 | 3 | 2 | 00001010s | | 9 |
| 31 | 4 | 1 | 00001011s | | 9 |
| 32 | 7 | 0 | 00001100s | | 9 |
| 33 | 8 | 0 | 00001101s | | 9 |

# FIG. 3

| Nr. | B | L | code word | length |
|-----|---|----|-----------|--------|
| 34 | 2 | 6 | 00001110s | 9 |
| 35 | 2 | 7 | 000001000s | 10 |
| 36 | 2 | 8 | 000001001s | 10 |
| 37 | 2 | 9 | 000001010s | 10 |
| 38 | 3 | 3 | 000001011s | 10 |
| 39 | 4 | 2 | 000001100s | 10 |
| 40 | 5 | 1 | 000001101s | 10 |
| 41 | 6 | 1 | 000001110s | 10 |
| 42 | 0 | 0 | 0000011111 | 10 |
| 43 | 2 | 10 | 0000011110s | 11 |
| 44 | 3 | 4 | 0000001000s | 11 |
| 45 | 3 | 5 | 0000001001s | 11 |
| 46 | 4 | 3 | 0000001010s | 11 |
| 47 | 5 | 2 | 0000001011s | 11 |
| 48 | 7 | 1 | 0000001100s | 11 |
| 49 | 2 | 11 | 0000001101s | 11 |
| 50 | 2 | 12 | 0000001110s | 11 |
| 51 | 2 | 13 | 0000001111s | 11 |
| 52 | 3 | 6 | 00000001000s | 12 |
| 53 | 3 | 7 | 00000001001s | 12 |
| 54 | 3 | 8 | 00000001010s | 12 |
| 55 | 4 | 4 | 00000001011s | 12 |
| 56 | 4 | 5 | 00000001100s | 12 |
| 57 | 5 | 3 | 00000001101s | 12 |
| 58 | 6 | 2 | 00000001110s | 12 |
| 59 | 8 | 1 | 00000001111s | 12 |
| 60 | 9 | 0 | 00001111s+++++++ | 16 |
| 61 | 0 | 1 | 00000000100000-- | 16 |
| 62 | 0 | 2 | 00000000100001-- | 16 |
| 63 | 0 | 3 | 00000000100010-- | 16 |
| 64 | 0 | 4 | 00000000100011-- | 16 |
| 65 | 0 | 5 | 00000000100100-- | 16 |

## FIG. 4

| Nr. | B | L | code word | length |
|-----|---|----|-----------------------|--------|
| 66 | 0 | 6 | 00000000100101-- | 16 |
| 67 | 0 | 7 | 00000000100110-- | 16 |
| 68 | 0 | 8 | 00000000100111-- | 16 |
| 69 | 0 | 9 | 00000000101000-- | 16 |
| 70 | 0 | 10 | 00000000101001-- | 16 |
| 71 | 0 | 11 | 00000000101010-- | 16 |
| 72 | 0 | 12 | 00000000101011-- | 16 |
| 73 | 0 | 13 | 00000000101100-- | 16 |
| 74 | 0 | 14 | 00000000101101-- | 16 |
| 75 | 2 | 14 | 00000000101110s- | 16 |
| 76 | 2 | 15 | 00000000101111s- | 16 |
| 77 | 3 | 9 | 00000000110000s- | 16 |
| 78 | 3 | 10 | 00000000110001s- | 16 |
| 79 | 4 | 6 | 00000000110010s- | 16 |
| 80 | 4 | 7 | 00000000110011s- | 16 |
| 81 | 4 | 8 | 00000000110100s- | 16 |
| 82 | 4 | 9 | 00000000110101s- | 16 |
| 83 | 5 | 4 | 00000000110110s- | 16 |
| 84 | 5 | 5 | 00000000110111s- | 16 |
| 85 | 6 | 3 | 00000000111000s- | 16 |
| 86 | 7 | 2 | 00000000111001s- | 16 |
| 87 | 8 | 2 | 00000000111010s- | 16 |

# FIG. 5

# FIG.6